# EUROPEAN PATENT SPECIFICATION

(11) **EP 2 795 352 B1**
(45) Date of publication and mention of the grant of the patent: **18.11.2015**
(21) Application number: 12790545.3
(22) Date of filing: 21.11.2012
(51) Int. Cl.: G01R 31/28

(54) **SIGNAL TEST CIRCUIT AND METHOD**
SIGNALTESTSCHALTUNG UND VERFAHREN
CIRCUIT ET PROCÉDÉ DE TEST DE SIGNAL

(30) Priority: 23.12.2011 GB 201122294; 16.02.2012 BE 201200097
(43) Date of publication of application: 29.10.2014
(73) Proprietor: Televic Rail NV, 8870 Izegem (BE)
(72) Inventor: EECKHOUT, Carl, B-8870 Izegem (BE); BAERT, Bram, B-8830 Hooglede (BE)
(74) Representative: DenK iP
(86) International application number: PCT/EP2012/073198
(87) International publication number: WO 2013/092082

(56) References cited:
- EP-A1- 0 572 204
- US-A- 4 724 380
- US-A1- 2007 219 739
- US-A1- 2009 284 263

## Description

### Field of the invention

The present invention is related to the field of circuits for testing input signals and methods for performing testing of such input signals.

### Background of the invention

In numerous applications and especially in safety applications it is relevant to test input circuits before using them in their application or to perform testing of the circuit during the application. Often the testing of these interfaces occurs by applying a reference signal to the input by changing the circuit input path. By doing so, a disconnection is made from the original input path.

However, in some cases the condition of the original input path is not known, therefore it is considered a risk to switch the input path to another source, since it cannot be guaranteed that switching back to the original source will occur correctly or that conclusions concerning the disconnected part are relevant.

Further it is desirable to be able to verify the input circuitry also during on-line operation. By using path disruptive verification techniques, the signal of interest cannot be monitored anymore and as such functionality is dropped.

Known solutions rely on hard switching of the input connection towards a reference signal. When opening the input path a proper switch back to the original input path after the test has been done, cannot be guaranteed in these cases. Further, the prior art solutions do not allow continuously monitoring the input circuit with respect to signal continuity, signal level and, for instance, digitizer interface correctness.

Additionally, there exists no methodology to implement testing of specific parameters in an intelligent and structured way to allow a reduction of the test resources, providing in certain compensations on the output stages in function of test actions provided on the input stage.

In US2009/284263 is disclosed a solution for in situ function testing of transducers comprising sensing elements and associated conditioning preamplifiers. Test signals and test sequence control signals are superposed on the wiring for the transducer output signal, yielding flexibility without sacrificing simplicity. Additional circuitry is provided in the transducer to interpret and route test signalling to the preamplifier based on signalling from a remote test generator. A remote analysing system is available for analysing the signals engendered from the test signals.

Application US2007/219739 relates to a mixer measurement system to characterize a mixer under test by means of a chaotic signal. The system includes a chaotic reference source, an excitation source at an input end of the mixer under test and an inverse system at an output end of the mixer under test. The inverse system removes a chaotic component from a response signal from the stimulated mixer under test to produce a recovered signal having an included distortion that is characteristic of the mixer under test. The method of characterizing a mixer includes applying the chaotic stimulation to the mixer under test to obtain a response signal and employing the inverse system to remove the chaotic component from the response signal.

Consequently, there is a need for overcoming the drawback of having to disrupt the original input path while performing input signal testing. There is also a need for an intelligent solution to determine the correct behaviour of the input circuits and the input signal itself. Tightly coupled, there is a need for issue (error, warning) reporting and interacting on the output signal.

### Summary of the invention

It is an object of embodiments of the present invention to provide for a solution for interface testing that allows for performing tests in a non-disruptive way, whereby the need to change the input path is avoided. It is a further object to present a solution for testing signal parameters in an intelligent way.

The above objective is accomplished by a device and method according to the present invention.

Embodiments of the present invention overcome the drawback of having to disconnect the original input path while performing input signal testing. In the solution according to the invention, it is clearly definable whether the test circuit is still applied or not. If the test system is not applied, then it can be guaranteed that the correct normal input conditions are applicable. However, the invention also makes sure that in case the test signal is still present, the signal of interest can still be isolated from the test signal, allowing monitoring of the analogue input circuit even during normal operation.

More in particular, the invention relates in a first aspect to a system for testing an input signal. The system comprises
- a test signal generation block arranged for producing a test signal based on analysis of the input signal and arranged for producing an updated test signal based on modifications,
- an input circuit comprising means for superposing the test signal to the input signal,
- a test interface in connection with the input circuit and adapted for analysing characteristics of the input signal and the test signal,
- a test control unit in connection with the test interface and the test signal generation block and arranged for defining updated test parameter settings and for deriving the modifications from the updated test parameter settings.

In the input circuit it is made sure no disconnection is needed to perform measurements with the test signal : the test signal is superposed on the applied input signal. In the test interface block the superposed test signal and input signal can be analysed. The test control unit receives information from the test interfaces and determines specifications for the test signal to be generated. These specifications are passed to the test signal generation block, where the actual test signal is produced and output.

In a preferred embodiment the input circuit is a sum amplifier. Such sum amplifier input circuit guarantees an exact compensation in case of an error due to wrong switching of the test signal on the input signal multiplexer. In case the compensation is performed digitally, in some configurations (e. g. a sum amplifier with gain factor of 2) it only requires a one bit shift to implement the appropriate gain.

In another preferred embodiment the input circuit is a galvanic isolated coupling.

Advantageously, the system further comprises an output stage.

By monitoring and controlling the output stage as well, by making use of this generic method, the output stage can be brought into a "safe" state in case input signal issues would be detected. As such the method provides not only in a clear reporting concerning an issue on the input circuit, but also provides in an adaptation of the output signal causing an implicit redundant effect on the evaluation of a certain signal. This redundant effect can be of high importance for safety related devices. The output stage is preferably arranged for compensating test parameters.

In another preferred embodiment the test control unit is adapted for outputting a safe state indication to the output stage.

In an advantageous embodiment the system further comprises multiplexing means for multiplexing a plurality of signals output by a plurality of input circuits. Several input signals can so be tested simultaneously using a same test signal. In that case the test interface is preferably arranged for being fed with signals in a time division multiplexed based (or a combination of permanent, temporarily or time division multiplexed based) style. Other multiplexing solutions can however be envisaged as well. Preferably signals fed to the test interface come from the output stage or from the input circuits.

Preferably the control block comprises a test sequencer for determining the sequence of parameters to be used.

In a preferred embodiment the control block is arranged for running an algorithm for determining the test parameters for the test signal.

The invention also presents a method for performance analysis of a signal carried over the input circuit and signal manipulation in function of its state or of the tests performed in order to provide a reliable and discontinued signal to higher level systems. More in particular, the method for testing a input signal comprises the steps of
- applying an input signal,
- generating a test signal based on test parameters obtained by analysis of said input signal,
- superposing the test signal on the input signal,
- performing an analysis on the superposition of the test signal and the input signal,
- defining updated test parameter settings for performing said testing from said analysis of said superposition and deriving from said updated test parameter settings modifications for said test signal,
- producing an updated test signal reflecting said modifications for continuing the testing.

When a testing is started, obviously one only has the input signal available. The input signal is analysed and based on that analysis test settings are determined as well as specifications for the test signal. This information is supplied to the test signal generation block, where the actual test signal is made. This test signal is then applied to the input circuit, where it is superposed on the input signal. From then on the superposition of test signal and input signal is analysed and the test signal is further updated based on analysis of the superposition, as explained above.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention.

### Brief description of the drawings

The invention will now be described further, by way of example, with reference to the accompanying drawings, in which:
Fig.1 represents a high level block scheme of the system according to the invention.
Fig.2 represents a detailed block scheme of an embodiment of the system of the invention.
Fig.3 represents the data connections used by the test algorithm.
Fig.4 represents a block scheme of an embodiment based on direct parallel sum-amplification.
Fig.5 represents a block scheme of an embodiment based on a galvanic test signal insertion.
Fig.6 represents an example of test signal adaptation in function of the input circuit parameter under investigation allowing validation of quantitative aspects of the input circuits.
Fig.7 represents a block scheme of an embodiment based on both a galvanic test signal insertion and the parallel sum-amplification.
Fig.8 represents an actual implementation example.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The solution presented in this invention overcomes the limitation of having to disconnect the original input path while performing input signal testing. It will be clearly definable whether the test circuit is still applied or not. If the test system is not applied, one can guarantee that the correct normal input condition is applicable. But also in case the test signal is still present, the signal of interest, i.e. the input signal, can still be isolated from the test signal, allowing monitoring of the input signal even during normal operation. A single test signal generator and analyser for multiple inputs can be employed. This means an optimization with respect to volume, cost as well as reliability. However, also more than one test signal generator and analyser can be used.

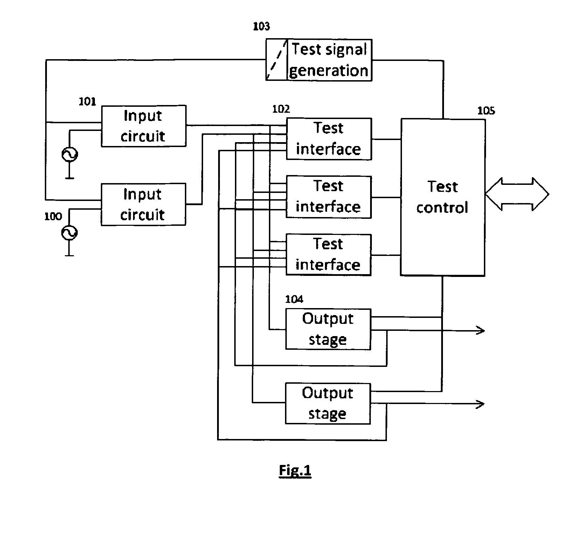

A general overview of the system according to the invention is provided in Fig.1. An input signal (100) is applied to an input circuit (101) wherein a test signal can be multiplexed on the input signal. The input signal constitutes the waveform under investigation. That waveform can be internal (e.g. a sine sweep signal allowing to verify the input circuit filter characteristics) or external (e.g. a correct external sensor signal generating a signal level larger than 4mA). In the input circuit the applied signals are processed. The input circuit (101) preferably comprises one or more subcircuits to adapt the signal to the requirements of the system handling this signal. The signal coming out of the input circuit (101) is fed to one or more test interfaces (102), wherein various functions are implemented for analysing certain signal aspects. The test interface circuits are arranged for operating on the test parameters of interest and for setting certain characteristics accordingly (e.g. related to filtering). The resulting signals of the test interfaces are passed to a test control unit (105). The latter comprises one or more logical units providing a correlated test application, test analysis, test reporting and output signal control. A test signal generation block (103) connected to the test control unit is adapted for generating an actual test signal complying with certain specifications received from the test control unit. One or more output stages (104) provide an output signal representative of the corresponding input signal or of the state the input signal is in.
In the test control unit (105) the settings for performing the test are prepared based on a test algorithm containing knowledge on the physical parameters of the signal, the input circuit (101) and the output stage (104). Once the test control unit has determined the actual test parameters, the test signals characteristics (like missing frequency components or signal levels) are determined and passed to the test signal generation block (103), where the actual physical test signal to be superposed on the input signal is generated.
Depending on the test signal and the way the test signal is modulated to the signal of interest, the output stage is controlled in such a way that the generated output signal is representative of the state of the input signal or the state the input circuit is in.
The condition of the output signal leaving the output stage is monitored by a similar test interface as the one applied on the input signal to validate proper behaviour of the output stage. In this way one can assure the compensation of the output signal is performed correctly.

The test control (105) unit can also contain an interface towards a higher level system communicating the internal status of the test system. The test control unit can in one embodiment be controlled in order to start or stop certain tests.

In some applications the input circuit block (101) only contains means for achieving a superposition of the input signal and the test signal, like e.g. a multiplexer or a relay, and is arranged for connecting the resulting superposed signal directly to the test interface. In other applications the input circuit additionally contains one or more components like a signal amplifier, an offset shifter, filters, protection devices and so on. The same can be stated with respect to the output stage. In certain embodiments the input circuit and the output stage are even controlled by the test control unit.

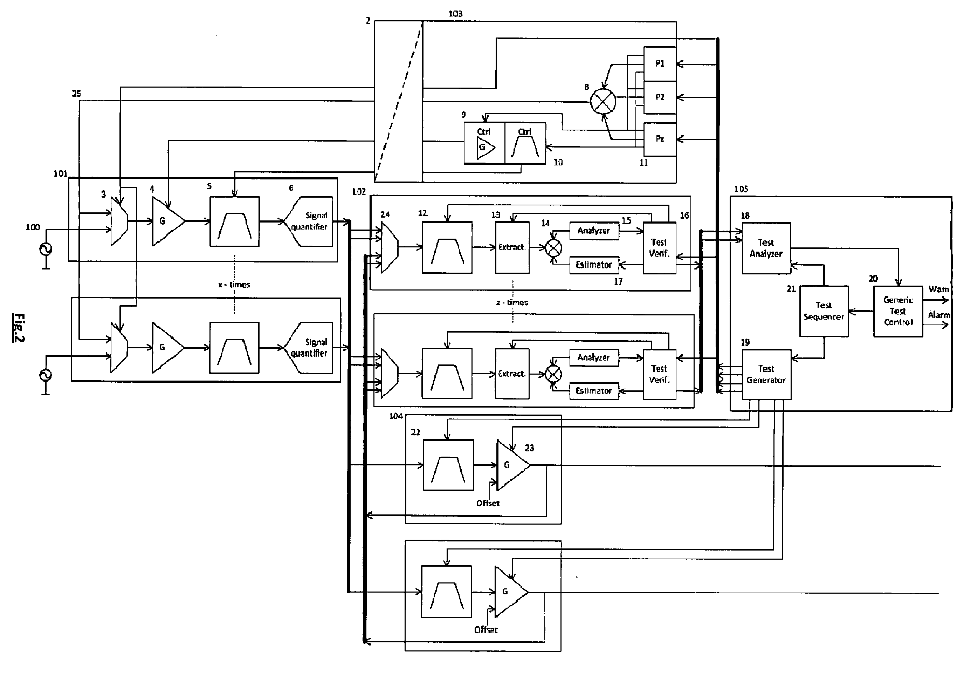

A detailed block scheme of an embodiment of the system according to the invention is provided in Fig.2. The input signal (100) under investigation may stem from a signal generator operable as input signal source. In practice, this can be implemented as a sensor or any other kind of signal generating device. The input signal may be analogue or digital. Optionally a test signal isolator (2) can be provided to establish a galvanic isolation between the test signal and the input signal. Via a multiplexer (3) the test signal can be connected to the input signal under control of the test signal generation block (103) that provides physical layer control. The input signal multiplexer block can be implemented as a multiplexing device but it can also be a modulator. Further down the signal path the input gain of the input signal may be adjusted by an input signal gain adjust block (4). A filter control block (5) allows for changing the input signal filter characteristics. In a signal quantifier (6) the analogue signal is converted to another representation. This can be an analogue to digital conversion or even a simple threshold detection which might be relevant for a digital signal.

In the test signal physical layer control block (103) a test signal is generated, possibly along with input circuitry control signals, based on the received input parameter(s) of the test signal. This may imply - among other things - control of the test signal multiplexer (3) setting, the input amplifier gain (4) setting and the input filter (5) settings. The actual test signal is generated in test signal generator (8). The input gain control block (9) comprises input signal gain controller means for controlling the input signal gain (4) based on the test signal generator input parameters (P1, P2, P3). Hence, the input signal gain control outputs a signal to be applied to the gain adjust block (4). Exactly the same can be stated for the input filter control block (10). Control block (103) comprises the input signal filter control (10) means to control the filter settings of the input signal filter (5) based on the test signal generator input parameters (P1, P2, P3) and to output a corresponding signal to the input signal filter (5). Controller (103) further comprises a test generator parameter control block (11), which defines the waveform of the test signal. There may be a plurality of such elements which are controlled in a consistent way by the test generator block (19) itself. The following test signal parameters can for example be controlled : amplitude, frequency, waveform, sample table (complex signal shape), ...

In the test interface (102) the test parameter input filter block (12) is controlled by a test parameter verification unit (16). The filter characteristics of this test parameter input filter block (12) are set in function of the test parameter to be monitored. The main task of the test parameter input filter block (12) is to pass the relevant input signal data in order to perform optimal verification of the test parameter(s) of interest, modulated by the test generator or present in the natural behaviour of the input signal. In the test parameter extractor (13) a specific analysis is performed to the applied input signal with respect to the test parameter of interest based on the input signal. This element can determine e.g. the level of a certain frequency component, the crest factor of the applied input circuit, ... The extractor (13) output is applied to a test parameter comparator (14), wherein the extracted test parameter is verified against a predefined condition controlled by a test parameter estimator (17). This condition depends on the test to be executed and can express e.g. whether a certain frequency component is present in the applied signal, whether this frequency has a certain level (<, >, =), a crest factor is met, complies to a certain spectrum, exceeds a certain level, ... All of this may be defined against specific tolerances. The test parameter analyser (15) captures the outcome of the test parameter comparator (14).

The test verification block (16) is responsible for controlling the test parameter extractor (13) and the test parameter input filter (12). It also generates the condition for parameter evaluation and generates the conclusion concerning the analysis of the parameter of interest.

The parameter estimator (17) contains the expected context to match the extracted parameter against. The context is applied to this element by the test verification block (16). The estimator may contain a sole value, like e.g. a threshold, but may as well be an entire spectrum or a crest factor, ....

The test control block (105) comprises a test analyser (18), a test generator (19), a test sequencer (21) and a generic test control unit (20).

The test analyser (18) combines the results of individual test parameter analysers (15) in the test interfaces (102) and, depending on the state of the test sequencer (21), evaluates whether the input or different inputs is/are in a good shape, i.e. the input circuits behave as expected. If this is not the case, an alarm will be generated. The result of this over-all test analysis is reported to the generic test control block (20). The test analyser can also verify the condition of the output signal in different positions in its output stage.

An important role in the operation of the system and more in particular of the test control block (105) is performed by the test generator (19). It transmits the test parameter conditions to the test signal generation block (103) taking into account the information already available in the input signal and imposing additional characteristics to the test signal in order to increase the total input signal path test coverage. It also applies test parameters to the individual test verification blocks (16) based on the status of the test sequencer (21). The test generator (19) also determines the conditions to be applied to the output signal components.

The generic test control block (20) provides an interface to a higher order system and allows starting the testing or a specific part thereof on one or more input signals. The status of the testing is reported by this block (20). This includes the condition of the testing resources as well as the condition of the selected input signals. The reporting concerns the exact type of issues that are detected with respect to the tested signals (e.g. input signal level too high), and/or the reporting with respect to the testing resources themselves, e.g. the test signal was not visible in the analysed signal, possibly due to an input multiplexer failure. It must be noted that in certain embodiments the control block can be accessed by a higher level system to force a test or to change test system parameters or to read certain information (status, internal state, alarms, warnings, parameter settings, ...). In the test sequencer (21) the required input is generated for the test analyser (18) and the test generator (19) in order to arrange a correlated execution of all individual tests on the input signals being performed in sequence and/or in parallel. This generator also controls the output signal path in order to perform compensations for the tests in execution or to bring the output in a "safe" condition. The test sequencer (21) starts a certain activity under control of the generic test control block (20).

The output signal filter (22) in the output stage (104) ensures that no intrusive test signal, potentially modulated onto the natural input signal, remains mixed into this useful signal. The filter settings can be adapted by the test generator (19) in view of the applied test parameters.

The settings of the output signal gain stage (23) are adaptable by the test generator (19) in function of the applied test parameters. This can be useful if the input signal level is modified by applying certain input circuit settings. This may also be used to implement a certain safe state in the output signal, e.g. by increasing or reducing the gain or applying a certain offset so that a certain higher order application triggering can occur.

The system architecture shown in Fig.2 represents only one embodiment of the invention. In alternative embodiments some of the functional blocks of Fig.2 may be grouped. A scalable solution, with a repetition of blocks combined, or not, with multiplexers, may be provided. Certain blocks can be repeated, in their largest or reduced form, to provide a multitude of input and output channels with only limited test resources. In certain embodiments only a subset of the components presented in Fig.2 may occur. As already mentioned several blocks in Fig.2 are optional.

In a further embodiment the test interface (102) can also be used to verify the natural behaviour of the signal. This means that, given the knowledge of the typical behaviour of the input signal, conditions can be defined with respect to this signal which can be monitored by the test interface (102). By way of example, this is typically applicable for industry standard analog 4-20mA interfaces. It is a given for these signals that the current should not be below 4mA and not be above 20mA. This can be monitored and tested by the method described above.

In another optional embodiment the test interface (102) is adapted to verify the output signal in the different output stages (104).

A further advantageous system feature concerns the application of a multiplexer (24) on the test parameter input filter (12) in the test interface (102). The test interface can so be reused for e.g. time-multiplexed analysis of multiple inputs, thus reducing resource needs.

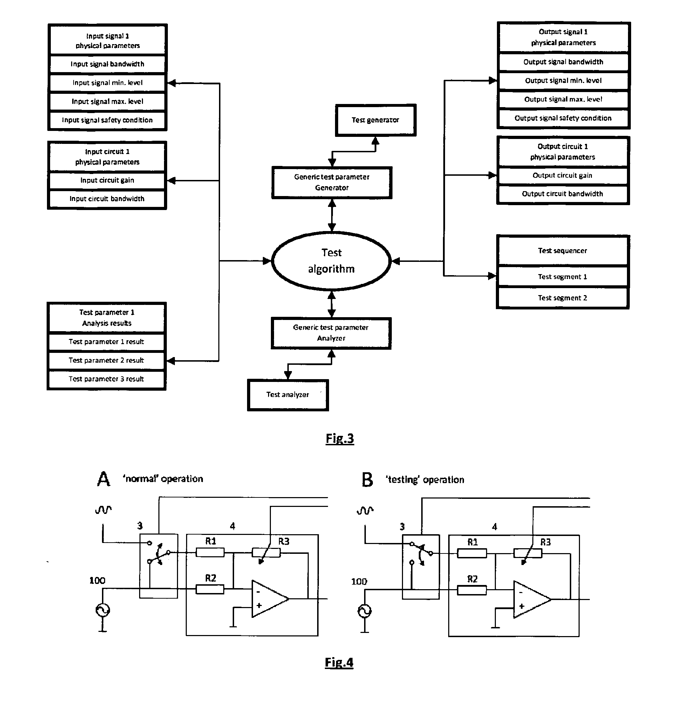

Fig 3 illustrates the behaviour of a possible implementation of the test algorithm carried out in the test control block (105). The test algorithm can be considered as distributed logic over the test control block (105) (i.e. the test analyser (18), test generator (19), test sequencer (21) and generic test control (20)). Based on the control applied to the test generator (19), the test sequencer schedules a number of test segments. The test segments are a set of test conditions which affect one or multiple input channels. The test conditions are based on the physical characteristics of the input signal and/or of the input circuits. The main objective of the test algorithm is to determine a test pattern which aims to reach maximal test coverage of the input path as well as prevention of intrusion to the input signal. This is obtained by defining a number of test parameters and related test patterns to verify certain physical aspects of the input signal and the input circuit without influencing the functional behaviour.
These parameters are configured by the algorithm into the test generator (19), which applies the effective test pattern to the input signal through the test signal generation block (103), and the test analyser (18), which observes the effects of the test signal on the input circuits. Because of the knowledge the test algorithm has about the output stage (104), in function of the applied test parameters, the test algorithm may decide to apply certain filter characteristics or gain settings to the output stage to compensate for the applied test conditions. Additionally, the algorithm may even decide, in function of the test result, to alter the output signal of the output stage in such a way that it implements a safe behaviour.

The following examples describe some advantageous possible implementations of a part of the input circuit (101) and provide an illustration of the generic approach presented previously. Reference is made to Fig.4.

In the direct parallel sum-amplification method shown in Fig.4, the intrusion of the test signal occurs by altering the insertion path of a sum-amplifier. In a 'normal' operational condition (Fig.4A) the input circuit is formed by applying an analogue input signal to a standard inverting amplifier which is formed by tying two sum-amplifier branches together over double valued normal gain series resistors (R1, R2). The input gain resistor is formed by the parallel resistor constellation. The second resistor (R2) is in the path because of the default position of the bipolar switch (3). As the input circuitry is also there without a test circuit or signal being present, it can be verified whether or not the input operates correctly/naturally by analysing the data from the standard input. During 'testing' operation (Fig.4B) the switch is altered so that a test signal generated by the test signal generation block (103) and the control logic in test control block (105) is applied to the sum-amplifier in this case. The standard path is not intruded and verification of the test signal is possible. At the moment of testing the analogue input signal and the test signal are split from one another by appropriate filters. Also a double gain is activated by the test control (105) block on the functional input signal at the output stage (104) level, compensating for the change in input amplification. Even if one fails to switch back to the normal case (which is detectable since the test signal still comes through), the signal can still be evaluated in the correct way.

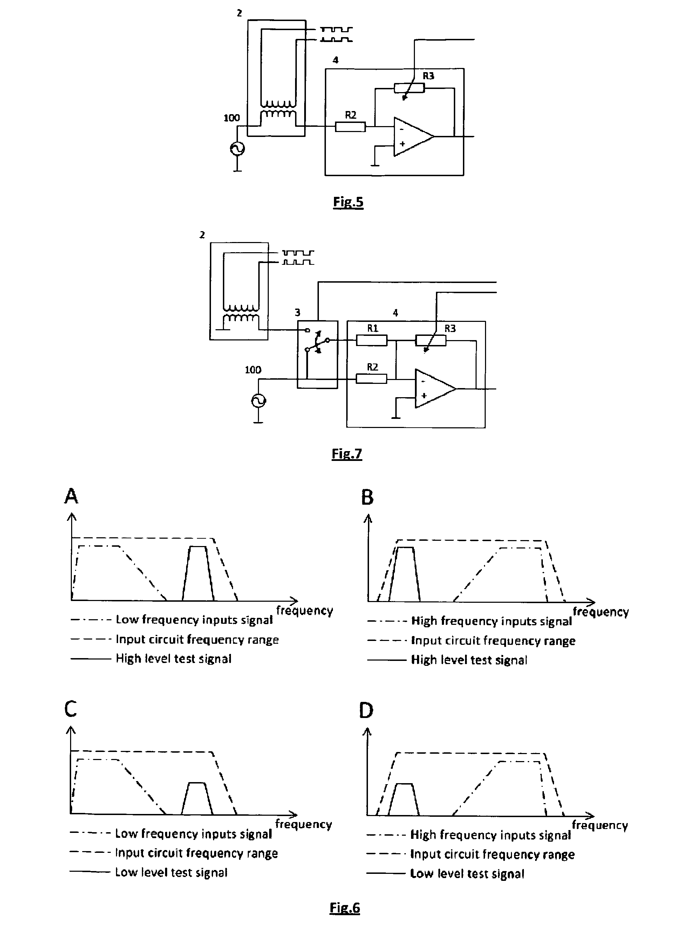

Another possible approach is illustrated in Fig.5, where a galvanic test signal intrusion is used. More in detail, a galvanic coupling (inductive, optical, ...) is made between a test signal and the analogue input itself. By applying a test signal to the component establishing the galvanic coupling, a signal is imposed to the standard test interface. As opposed to the parallel sum-amplification of Fig.4 no modifications are made to the input circuit. Thus no interruption is made to the standard path or to the gain of the 'normal' operation signal. At the moment of testing the analogue input signal and the test signal are split from one another by appropriate filters.

Both in case of galvanic or direct test signal intrusion and parallel sum-amplification one can apply the test signal continuously by providing an intelligent test signal generator and input signal analyser. The signal generator then outputs a test signal to the coupling device based on the actual measured input circuit. It generates a test signal out of the useful frequency range of the analogue input signal. Also the test signal level is adaptable. This mechanism allows verifying the complete analogue input path with respect to signal continuity and signal level. This latter feature even allows continuously evaluating the operational range of the analogue circuit and/or of the digital interface of for instance the digitizer.

By making the test signal generator intelligent so that the actual analogue input signal is used to determine the characteristics w.r.t. , amongst other, frequency and level of the test signal, input path verification can occur continuously. Fig.6 provides an illustration on inserting test signal outside the input signal frequency band with modulated signal level. By applying a test signal which is outside the band of the input signal, as an example, it is possible to validate the correct operation of an analog to digital conversion device or to verify if the signal is, or is not, filtered away by input circuits. Fig. 6 shows how the test signal is generated outside the band of the input signal. This can be of higher frequencies or of lower frequencies.

The above examples should be seen as such and therefore not limiting the invention. To illustrate this, in a further embodiment a combination of the above shown examples, as shown in Fig.7, is possible. In Fig.7 both a galvanic test signal insertion and the parallel sum-amplification are applied.

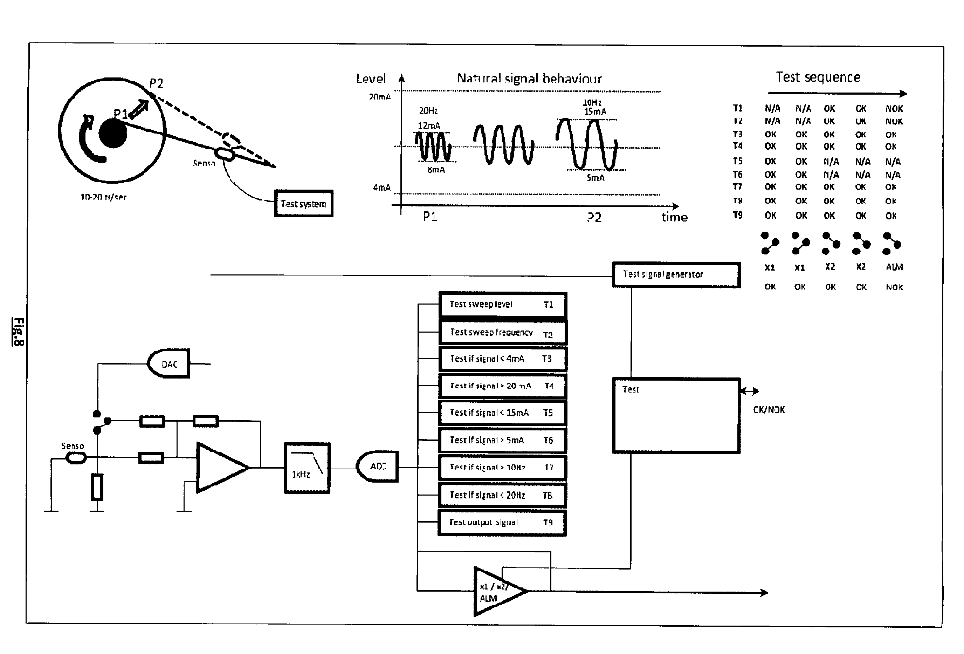

A typical operational example situation is described based on the situation provided in Fig. 8. It concerns a rotating machine with a linear distance encoder with analogue current output. The linear encoder registers the rotating movement of a winding machine which operates between two diameters determined by P1 and P2. During the winding process, the crank shaft, connected to the linear encoder, is moving from P1 to P2. The winding rotation speed is variable between 10Hz and 20Hz. It is now described how to determine the natural behaviour of the sensor signal. This signal should (only the operational behaviour of the machine is assumed) have a frequency between 10Hz and 20Hz and the measured level should range between 5mA and 15mA. If these conditions are not met, there is a machine issue (crank shaft, sensor mounting, winding machine). In case the sensor signal is smaller than 4mA or larger than 20mA there is clearly a sensor issue. However, there could also be an issue with either the sensor, the input circuit or their interconnection. In order to verify this, the test control unit can apply a frequency sweep with certain levels (the test algorithm may verify this by dynamically use the information which is already present in the natural signal in order not to intrude the natural behaviour of the sensor signal) and insert this on the sensor signal by altering the test switch. At this moment, the output gain is adapted as well in order to compensate for the input change.
In order to verify that the system indeed provides in the correct output, the output itself is also monitored.
In case the test algorithm detects an error, an error is reported and the output signal is put into the safe alarm condition. This could be e.g. all zeroes.
By changing the sweep level and frequency, the test algorithm is capable of testing the gain of the input circuit, the bandwidth of the input filter and the correct functioning of the ADC.
All these tests are scheduled by the test sequencer, performing the test segments in parallel or sequential based on interdependence parameters of the test segments and test circuits.

The proposed solution offers a wide variety of advantages. One signal generator is required for the testing of multiple inputs. This clearly constitutes an optimization in terms of volume, cost and reliability. The test signal can be used to multiple inputs with similar characteristics. An important benefit is - as already mentioned - that inputs can be disconnected from the test signal which could be influenced from said test signal. Further, multiple parameters of the input circuit can be verified. The proposed approach also allows verifying the output signal condition. The input signal connectivity remains guaranteed at all times.

Another important feature of the proposed system is its ability to allow on-line input circuit measurement and verification. A status indication can be obtained. The system is scalable and can be multiplexed in time. The output signal can be modulated to a safe condition. Specific behaviour of the input and the output signals can be verified.

Further benefits offered by the invention can be summarised as follows. The connectivity of the input signal can be guaranteed at all times. It allows applying the test signal to multiple inputs with similar characteristics. Inputs, which can be influenced from the test signal, can be disconnected from the test signal. At any time one can detect whether the test signal is still connected to the input.

Next to the handling of test input connectivity, the present disclosure also presents a method for adapting the input circuitry for specific test signal verification, a solution for specific test parameter verification, for the test pattern generation and for over-all test parameter verification.

Due to the invention a test signal can be inserted into an interface circuit by a galvanic method or by a sum-amplifier based method. It also offers a way to generate a specific test signal to allow on-line measurement and a method to use the data of the available circuitry to analyse the test data and to extract the signal of interest.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

## Claims

1. System for testing a input signal (100), said system comprising
- a test signal generation block (103) arranged for producing a test signal (25) based on analysis of said input signal (100) and arranged for producing an updated test signal based on modifications,
- an input circuit (101) comprising means for superposing said test signal (25) to said input signal (100),
- a test interface (102) in connection with said input circuit and adapted for analysing characteristics of the superposition of said input signal and said test signal coming out of said input circuit,
- a test control unit (105) in connection with said test interface (102) and said test signal generation block (103) and arranged for defining updated test parameter settings from the analysis of said characteristics of said superposition and for deriving said modifications from said updated test parameter settings.

2. System for testing as in claim 1, wherein said input circuit (101) is implemented as a sum amplifier.

3. System for testing as in claim 1, wherein said input circuit (101) is a galvanic isolated coupling.

4. System for testing as in any of claims 1 to 3, further comprising an output stage (104).

5. System for testing as in claim 4, wherein said output stage is arranged for compensating said test parameters.

6. System for testing as in claim 4 or 5, wherein said test control unit (105) is adapted for outputting a safe state indication to said output stage.

7. System for testing as in any of the previous claims, further comprising multiplexing means (24) for multiplexing a plurality of signals output by a plurality of input circuits (101).

8. System for testing as in claim 7, wherein said test interface (102) is arranged for being fed with signals in a time division multiplexed based style.

9. System for testing as in claim 8, wherein said signals fed to said test interface (102) come from said output stage or from said input circuits.

10. System for testing as in any of the previous claims, wherein said control block (105) comprises a test sequencer (21) for determining the sequence of parameters to be used.

11. System for testing as in any of the previous claims, wherein said control block (105) arranged for running an algorithm for determining said test parameters for said test signal.

12. Method for testing a input signal (100), comprising the steps of
- applying an input signal (100),
- generating a test signal (25) based on test parameters obtained by analysis of said input signal,
- superposing said test signal (25) on said input signal (100),
- performing an analysis on the superposition of said test signal and said input signal,
- defining updated test parameter settings for performing said testing from said analysis on the superposition and deriving from said updated test parameter settings modifications for said test signal,
- producing an updated test signal reflecting said modifications for continuing the testing.

## Patentansprüche

1. System zum Testen eines Eingangssignals (100), wobei das besagte System folgendes umfasst
- einen Block (103) zum Generieren eines Testsignals, der ausgeführt ist, um ein Testsignal (25) basierend auf der Analyse des besagten Eingangssignals (100) zu erzeugen und der ausgeführt ist, um ein auf Änderungen basierendes aktualisiertes Testsignal zu erzeugen,
- einen Eingangskreis (101), der Mittel zum Überlagern des besagten Testsignals (25) und des besagten Eingangssignals (100) umfasst,
- eine Testschnittstelle (102), die in Verbindung mit dem besagten Eingangskreis steht, und ausgeführt ist, um Eigenschaften der Überlagerung des besagten Eingangssignals und des besagten Testsignals zu analysieren, das aus dem besagten Eingangskreis stammt,
- eine Teststeuereinheit (105) in Verbindung mit der besagten Testschnittstelle (102) und dem besagten Block (103) zum Generieren eines Testsignals, die ausgeführt ist, um aktualisierte Testparametereinstellungen aus der Analyse der besagten Eigenschaften der besagten Überlagerung zu definieren, und um die besagten Änderungen aus den besagten aktualisierten Testparametereinstellungen abzuleiten.

2. System zum Testen nach Anspruch 1, wobei der besagte Eingangskreis (101) als Summenverstärker ausgeführt ist.

3. System zum Testen nach Anspruch 1, wobei der besagte Eingangskreis (101) eine galvanisch isolierte Kopplung ist.

4. System zum Testen nach irgendeinem der Ansprüche 1 bis 3, das darüber hinaus eine Ausgangsstufe (104) umfasst.

5. System zum Testen nach Anspruch 4, wobei die besagte Ausgangsstufe ausgeführt ist, um die besagten Testparameter zu kompensieren.

6. System zum Testen nach Anspruch 4 oder 5, wobei die besagte Teststeuereinheit (105) ausgeführt ist, um der besagten Ausgangsstufe einen Hinweis auf einen sicheren Zustand auszugeben.

7. System zum Testen nach irgendeinem der vorherigen Ansprüche, das darüber hinaus Multiplexing-Mittel (24) zum gleichzeitigen Übertragen einer Vielzahl von Signalen umfasst, die durch eine Vielzahl von Eingangskreisen (101) ausgegeben werden.

8. System zum Testen nach Anspruch 7, wobei die besagte Testschnittstelle (102) ausgeführt ist, um mit Signalen im Zeitmultiplexverfahren versorgt zu werden.

9. System zum Testen nach Anspruch 8, wobei die besagten Signale, mit denen die besagte Testschnittstelle (102) versorgt wird, von der besagten Ausgangsstufe oder von den besagten Eingangskreisen stammen.

10. System zum Testen nach irgendeinem der vorherigen Ansprüche, wobei der besagte Steuerblock (105) einen Testsequenzer (21) zum Bestimmen der zu verwendenden Parametersequenzen umfasst.

11. System zum Testen nach irgendeinem der vorherigen Ansprüche, wobei der besagte Steuerblock (105) ausgeführt ist, um einen Algorithmus laufen zu lassen, um die besagten Testparameter für das besagte Testsignal zu bestimmen.

12. Verfahren zum Testen eines Eingangssignals (100), die folgenden Schritte umfassend
- Anwenden eines Eingangssignals (100),
- Generieren eines Testsignals (25) basierend auf Testparametern, die man durch die Analyse des besagten Eingangssignals erhält,
- Überlagern des besagten Testsignals (25) und des besagten Eingangssignals (100),
- Ausführen einer Analyse an der Überlagerung des besagten Testsignals und des besagten Eingangssignals,
- Definieren aktualisierter Testparametereinstellungen zum Ausführen des besagten Tests aus der besagten Analyse an der besagten Überlagerung und Ableiten von Änderungen aus den besagten Testparametereinstellungen für das besagte Testsignal,
- Erzeugen eines aktualisierten Testsignals als Widerspiegelung der besagten Änderungen zur Fortführung des Tests.

## Revendications

1. Un système de test d'un signal en entrée (100), ledit système comprenant
- un bloc de génération de signal de test (103) agencé de façon à produire un signal de test (25) en fonction d'une analyse dudit signal en entrée (100) et agencé de façon à produire un signal de test actualisé en fonction de modifications,
- un circuit d'entrée (101) comprenant un moyen de superposition dudit signal de test (25) sur ledit signal en entrée (100),
- une interface de test (102) raccordée audit circuit d'entrée et adaptée de façon à analyser des caractéristiques de la superposition dudit signal en entrée et dudit signal de test provenant dudit circuit d'entrée,
- une unité de commande de test (105) raccordée à ladite interface de test (102) et audit bloc de génération de signal de test (103) et agencée de façon à définir des réglages de paramètres de test actualisés à partir de l'analyse desdites caractéristiques de ladite superposition et de façon à dériver lesdites modifications à partir desdits réglages de paramètres de test actualisés.

2. Le système de test selon la Revendication 1, où ledit circuit d'entrée (101) est mis en oeuvre sous la forme d'un amplificateur de somme.

3. Le système de test selon la Revendication 1, où ledit circuit d'entrée (101) est un couplage isolé galvanique.

4. Le système de test selon l'une quelconque des Revendications 1 à 3, comprenant en outre un étage de sortie (104).

5. Le système de test selon la Revendication 4, où ledit étage de sortie est agencé de façon à compenser lesdits paramètres de test.

6. Le système de test selon la Revendication 4 ou 5, où ladite unité de commande de test (105) est adaptée de façon à produire en sortie une indication d'état sûr audit étage de sortie.

7. Le système de test selon l'une quelconque des Revendications précédentes, comprenant en outre un moyen de multiplexage (24) destiné au multiplexage d'une pluralité de signaux produits en sortie par une pluralité de circuits d'entrée (101).

8. Le système de test selon la Revendication 7, où ladite interface de test (102) est agencée de façon à être alimentée avec des signaux dans un style à base de multiplexage à répartition dans le temps.

9. Le système de test selon la Revendication 8, où lesdits signaux envoyés vers ladite interface de test (102) proviennent dudit étage de sortie ou desdits circuits d'entrée.

10. Le système de test selon l'une quelconque des Revendications précédentes, où ledit bloc de commande (105) comprend un séquenceur de tests (21) destiné à la détermination de la séquence de paramètres à utiliser.

11. Le système de test selon l'une quelconque des Revendications précédentes, où ledit bloc de commande (105) est agencé de façon à exécuter un algorithme destiné à la détermination desdits paramètres de test pour ledit signal de test.

12. Un procédé de test d'un signal en entrée (100), comprenant les opérations suivantes :
- l'application d'un signal en entrée (100),
- la génération d'un signal de test (25) en fonction de paramètres de test obtenus par une analyse dudit signal en entrée,
- la superposition dudit signal de test (25) sur ledit signal en entrée (100),
- l'exécution d'une analyse de la superposition dudit signal de test et dudit signal en entrée,
- la définition de réglages de paramètres de test actualisés destinés à l'exécution desdits tests à partir de ladite analyse de la superposition et la dérivation à partir desdits réglages de paramètres de test actualisés de modifications pour ledit signal de test,
- la production d'un signal de test actualisé réfléchissant lesdites modifications en vue de la poursuite des tests.
